# EUROPEAN PATENT SPECIFICATION

(11) **EP 1 465 014 B1**
(45) Date of publication and mention of the grant of the patent: **06.08.2008**
(21) Application number: 04251284.8
(22) Date of filing: 05.03.2004
(51) Int. Cl.: G03F 7/20, H02K 41/00, H02K 41/02

(54) **Lithographic apparatus, device manufacturing method and device manufacturated thereby**
Lithographischer Apparat, Verfahren zur Herstellung eines Artikels und damit erzeugter Artikel
Appareil lithographique, procédé pour la production d'un dispositif et dispositif produit par ce procédé

(30) Priority: 11.03.2003 EP 03251446
(43) Date of publication of application: 06.10.2004
(73) Proprietor: ASML Netherlands B.V., 5504 DR Veldhoven (NL)
(72) Inventor: Hol, Sven Antoin Johan, 5623 AW Eindhoven (NL); Buijs, Edwin Johan, 5951 GZ Belfeld (NL); Van Der Schoot, Harmen Klaas, 5262 RK Vught (NL); Vreugdewater, Patricia, 5658 BC Eindhoven (NL)
(74) Representative: Leeming, John Gerard

(56) References cited:
- US-A- 6 081 179
- US-A1- 2002 096 946
- US-B1- 6 476 383

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a Lorentz actuator, comprising a coil arrangement in thermal contact with at least one cooling element.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

A commonly used actuator in this field is the Lorentz actuator. In such a device, an actuating force is derived from the magnetic field associated with a current driven through a suitably arranged coil. Short stroke Lorentz actuators are used to provide a driving means between the substrate or mask stage and the mirror block, on which the substrate or mask is mounted. Large current densities are required in order to provide sufficiently powerful and compact actuators, which leads to significant dissipative heating within the coils. Cooling elements consisting of thermally conductive plates are conventionally provided on the top and bottom of the coils, with water flowing in built-in water channels acting to remove the heat. However, during operation the efficiency of the Lorentz actuator is limited by eddy currents induced in the body of the cooling plates by time-varying external magnetic fields. Materials that are good thermal conductors (i.e. metals) are also good electrical conductors. Damping forces arising from the generation of eddy currents degrades the dynamical performance of the actuator and the associated dissipative heating degrades the thermal performance. Materials with lower electrical conductivity but acceptable thermal conductivity, such as ceramics, suffer less from eddy current heating than metals but it is found that machining of the cooling channels in these materials tends to introduce micro-cracks and imperfections that reduce machine reliability by increasing the risk of coolant leakage and mechanical failure. In EUV systems, the heat sensitivity of critical components is such as to place severe constraints on the amount of heat that can be allowed to radiate from the coils to the mirror block. In these types of systems, the prior art configurations of cooling plate are not sufficient to adequately control the temperature of the coils.

Lorentz actuators are described, for example, in US 2002/0096946.

It is an object of the present invention to provide a Lorentz actuator with reduced eddy currents in a cooling element.

This and other objects are achieved according to the invention in a lithographic projection apparatus comprising:
- a radiation system for providing a projection beam of radiation;
- a support structure for supporting patterning means, the patterning means serving to pattern the projection beam according to a desired pattern;
- a substrate tablefor holding a substrate;
- a projection system for projecting the patterned beam onto a target portion of the substrate; and
- a Lorentz actuator, comprising a coil arrangement in thermal contact with at least one cooling element, wherein:

- one or more slits are provided in said cooling element, arranged so as to increase the electrical resistance of eddy current paths, characterized by further comprising:

- cooling channels integrated with the slits in such a way as to provide a plurality of parallel paths arranged to reduce flow impedance, and formed within the cooling element.

The slits in the cooling element thus provided act as barriers for the circulating eddy currents, obliging them to take paths of higher electrical resistance. This has the effect of reducing the size of the eddy currents, thus reducing damping forces and the levels of dissipative heating.

According to a preferred embodiment, the slits are arranged to be parallel to each other. This arrangement encourages a uniform eddy current flow, which helps reduce uneven temperature distributions within the cooling element.

According to a further preferred embodiment, the slits are arranged to be perpendicular to the direction of the induced electric field. This arrangement is particularly effective in increasing the resistance of eddy current paths and reducing thereby the level of damping and heating.

According to a still further preferred embodiment, the slits are arranged to be substantially parallel or at a substantially oblique angle to the direction of the induced electric field. This arrangement can be more efficiently integrated with certain device arrangements and remains effective in increasing the resistance of eddy current paths and reducing thereby the level of damping and heating.

According to still further preferred embodiments, it is possible to optimise the integration of cooling channels with the slits of the cooling element. In particular, the lengths of the slits can be limited so as not to extend across the entire length of the cooling element to allow more room for cooling channels to be arranged in an efficient way. As an example, adjacent slits may be arranged to extend from opposite sides of the cooling element. Additionally, it is preferable that the cooling channels are arranged so as to have multiple parallel paths wherever possible. This has the effect of reducing the flow impedance through the cooling channel network, thus allowing larger flow rates to be achieved for the same pressure difference. Furthermore, a more symmetrical network allows for a more even coverage of the cooling element thus improving the uniformity of the cooling power.

According to a still further preferred embodiment, the slits may be filled so as to protect from outgassing from the coils.

The above embodiments describe improvements to the Lorentz actuator that result in improved damping behaviour, reduced hotspot temperatures and overall radiation levels to surrounding heat sensitive components such as the mirror block, and reduced actuator mass and volume since the more effective cooling allows for increased current densities.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and
- operating a Lorentz actuator, which comprises a coil arrangement in thermal contact with at least one cooling element, wherein:

- one or more slits are provided in said cooling element, arranged so as to increase the electrical resistance of eddy current paths, characterized in that cooling channels are integrated with the slits in such a way as to provide a plurality of parallel paths arranged to reduce flow impedance, and are formed within the cooling element.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a side view of the magnetic assembly for a Lorentz actuator showing the coil with attached cooling elements;
Figure 3 depicts a top view of a Lorentz actuator with cooling elements showing eddy current flow;
Figure 4 depicts a top view of a Lorentz actuator with cooling element showing portion susceptible to eddy currents;
Figure 5 depicts a top view of a Lorentz actuator with a slitted cooling element according to a preferred embodiment of the present invention;
Figure 6 depicts a top view of a Lorentz actuator with a slitted cooling element according to a further preferred embodiment of the present invention;
Figure 7 depicts a top view of a Lotentz actuator with a slitted cooling element according to a still further preferred embodiment of the present invention showing the complementary arrangement of cooling channels with the slits.

In the Figures, corresponding reference symbols indicate corresponding parts.

### Embodiment 1

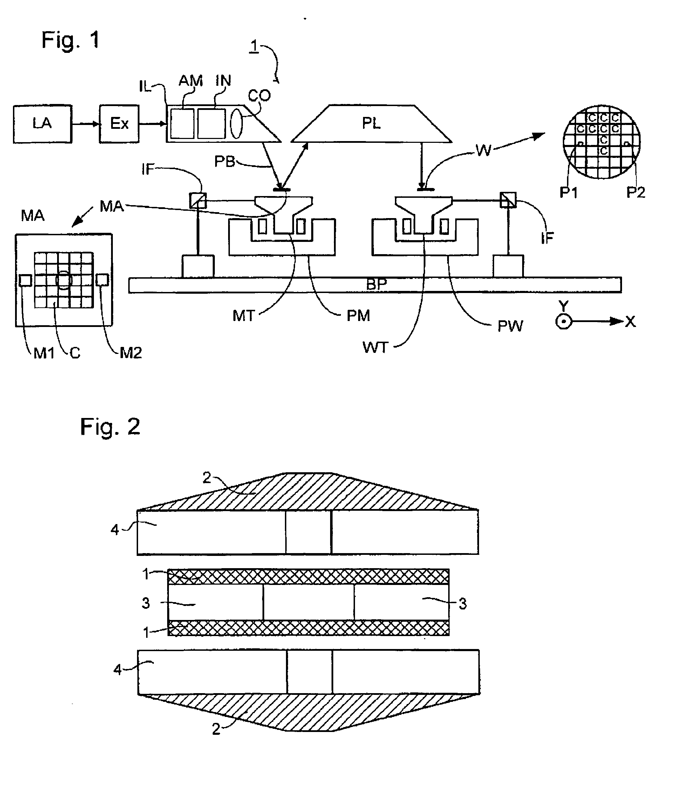

Figure 1 schematically depicts a lithographic projection apparatus according to a particular embodiment of the invention. The apparatus comprises:
· a radiation system Ex, IL, for supplying a projection beam PB of radiation (*e.g*. EUV radiation), which in this particular case also comprises a radiation source LA;
· a first object table (mask table) MT provided with a mask holder for holding a mask MA (*e.*g. a reticle), and connected to first positioning means for accurately positioning the mask with respect to item PL;
· a second object table (substrate table) WT provided with a substrate holder for holding a substrate W (*e.g*. a resist-coated silicon wafer), and connected to second positioning means for accurately positioning the substrate with respect to item PL;
· a projection system ("lens") PL (*e.g*. a mirror group) for imaging an irradiated portion of the mask MA onto a target portion C (*e.g*. comprising one or more dies) of the substrate W.
As here depicted, the apparatus is of a reflective type (*e.g*. has a reflective mask). However, in general, it may also be of a transmissive type, for example (*e*.*g*. with a transmissive mask). Alternatively, the apparatus may employ another kind of patterning means, such as a programmable mirror array of a type as referred to above.

The source LA (*e.*g. a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g*. so as to position different target portions C in the path of the beam PB. Similarly, the first positioning means can be used to accurately position the mask MA with respect to the path of the beam PB, *e.g*. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i*.*e*. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e*.*g*. the y direction) with a speed *v*, so that the projection beam PB is caused to scan over a mask image; concurrently, the substrate table WT is simultaneously moved in the same or opposite direction at a speed *V* = *Mv,* in which *M* is the magnification of the lens PL (typically, *M* = 1/4 or 1/5). In this manner, a relatively large target portion C can be exposed, without having to compromise on resolution.

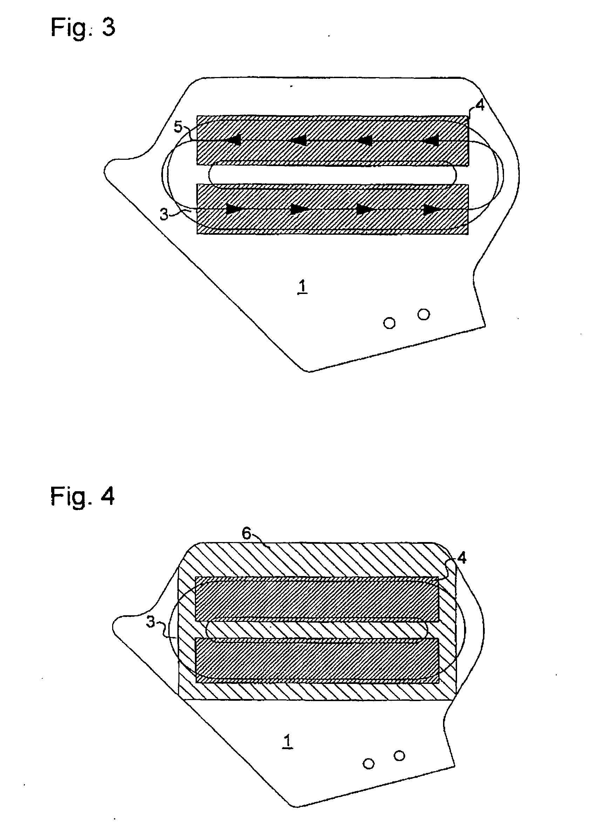

Figure 2 depicts a side view of the magnetic assembly for a Lorentz actuator. In a typical application, the coil unit, which consists of a coil 3 and cooling elements 1 is connected to the long stroke of the substrate or mask stage (WT or MT), while the magnets 4 with back irons 2 are connected to the short stroke of the mirror block, on which the substrate W or mask MA is mounted. In operation, changing magnetic fields linked by the conductive material of the cooling elements 1 cause eddy currents 5 to flow in the cooling elements 1. The sense of these eddy currents 5 is shown in Figure 3, for an increasing field directed into the page. The creation of eddy currents 5 provides a drag or damping force that opposes the actuator and reduces its performance. In addition, heat dissipated by the circulating currents reduces the effectiveness of the cooling element 1. This latter effect can be particularly damaging in EUV systems where a number of components are highly sensitive' to thermal expansion, which can be induced by radiation from warmer elements nearby.

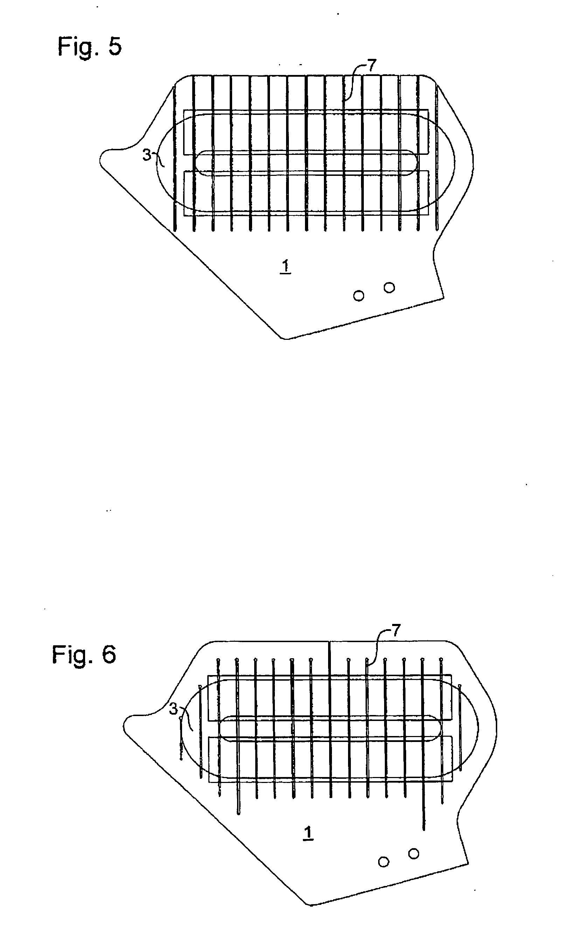

The area 6 of the cooling plates 1 that is particularly prone to eddy currents, and in which it is most effective to locate means to control eddy currents 5, is indicated in Figure 4. Figure 5 illustrates how eddy currents 5 may be controlled according to the present invention by introducing slits 7 in the cooling element 1. Since the resistance across the slits 7 is extremely high, currents are forced to circulate around longer paths of smaller average cross-sectional area. Eddy currents 5 are therefore reduced due to the increased resistance of the eddy current paths. The dissipated heat varies as the square of the current and is therefore also reduced, as is the damping force.

The arrangement in Figure 5 corresponds to a further preferred embodiment of the invention wherein the slits 7 are parallel to each other. This arrangement is beneficial because it favours a more uniform eddy current flow, so that induced temperature increases are spread out and reduced in magnitude. The slits are also arranged to be largely perpendicular to the eddy current flow depicted in Figure 3. This arrangement is desirable because it is particularly effective in increasing the resistance of eddy current paths. Alternatively, it may be more desirable to arrange the slits to be parallel or at an oblique angle to the induced field in order to more efficiently coordinate with surrounding device components and to reduce manufacturing costs. These alternative arrangements can also achieve satisfactory increases in the resistance of eddy current paths.

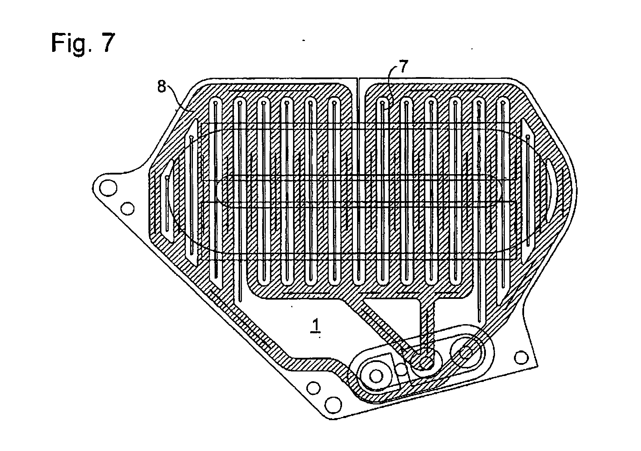

Figures 6 and 7 depict an arrangement of slits 7 according to a further preferred embodiment of the present invention. Here, the slits 7 are reduced in length in order to accommodate cooling channels in a more efficient manner. Although it is not essential for the slits 7 to cut completely through the cooling element 1, it is preferable that the slits penetrate through a major part of the cross-section. For cooling channels 8 of reasonable cross-sectional area, therefore, it is necessary that they avoid the slits 7. Additionally, for optimal cooling and reliability, it is necessary to achieve a rapid and maximally uniform flow of coolant through the cooling element 1. An example arrangement for achieving this is depicted in Figure 7. For a given pressure gradient driving the flow of coolant, the flow rate depends on the flow impedance of the cooling channel network. The flow impedance of the network depicted in Figure 7 is kept low by using short sections of cooling channel 8 connected together in parallel. According to the implementation in question, the cooling channels 8 may have a substantially circular or a substantially rectangular cross-section.

Whilst specific embodiments of the invention have been described above, it will be appreciated that the invention may be practiced otherwise than as described. The description is not intended to limit the invention.

## Claims

1. A lithographic projection apparatus comprising:
a radiation system (LA) for providing a projection beam of radiation (PB);
- a support structure (MT) for supporting patterning means (MA), the patterning means (MA) serving to pattern the projection beam (PB) according to a desired pattern;
- a substrate table (WT) for holding a substrate (W);
- a projection system (PL) for projecting the patterned beam (PB) onto a target portion of the substrate (W); and
- a Lorentz actuator, comprising a coil arrangement (3) in thermal contact with at least one cooling element (1), wherein:
- one or more slits (7) are provided in said cooling element (1), arranged so as to increase the electrical resistance of eddy current paths, **characterized by** further comprising:
- cooling channels (8) integrated with the slits (7) in such a way as to provide a plurality of parallel paths arranged to reduce flow impedance, and formed within the cooling element.

2. A lithographic projection apparatus according to claim 1, wherein the slits (7) are arranged to be substantially parallel to each other.

3. A lithographic projection apparatus according to any one of the preceding claims, wherein the slits (7) are arranged to be substantially perpendicular to the direction of the induced electric field.

4. A lithographic projection apparatus according to any of the claims 1-2, wherein the slits (7) are arranged to be substantially parallel, or at a substantially oblique angle, to the direction of the induced electric field.

5. A lithographic projection apparatus according to any one of the preceding claims wherein the slit lengths are limited so as not to extend across the entire length of the cooling element (1).

6. A lithographic projection apparatus according to any one of the preceding claims wherein adjacent slits (7) extend from opposite sides of the cooling element (1).

7. A lithographic projection apparatus according to any of the preceding claims wherein cooling channels (8) are arranged in a substantially symmetrical network to provide uniform coverage of the cooling element (1).

8. A lithographic projection apparatus according to any one of the preceding claims wherein the slits (7) are filled to protect from outgassing from the coil (3).

9. A device manufacturing method comprising the steps of:
- providing a substrate (W) that is at least partially covered by a layer of radiation-sensitive material;
- providing a projection beam of radiation (PB) using a radiation system(LA);
- using patterning means (MA) to endow the projection beam (PB) with a pattern in its cross-section;
- projecting the patterned beam of radiation (PB) onto a target portion of the layer of radiation-sensitive material; and
- operating a Lorentz actuator, which comprises a coil arrangement (3) in thermal contact with at least one cooling element (1), wherein:
- one or more slits are provided in said cooling element (1), arranged so as to increase the electrical resistance of eddy current paths, **characterized in that** cooling channels (8) are integrated with the slits (7) in such a way as to provide a plurality of parallel paths arranged to reduce flow impedance, and are formed within the cooling element.

## Patentansprüche

1. Lithographische Projektionsvorrichtung, mit:
• einem Strahlungssystem (LA) zum Bereitstellen eines Projektionsstrahls aus Strahlung (PB);
• einer Haltekonstruktion (MT) zum Halten von Musteraufbringungseinrichtungen (MA), wobei die Musteraufbringungseinrichtungen (MA) dazu dienen, den Projektionsstrahl (PB) gemäß einem gewünschten Muster zu mustern;
• einem Substrattisch (WT) zum Halten eines Substrats (W);
• einem Projektionssystem (PL) zum Projizieren des gemusterten Strahls (PB) auf einen Zielbereich des Substrats (W); und
• einem Lorentz-Aktuator, der eine Spulenanordnung (3) in Thermokontakt mit wenigstens einem Kühlelement (1) umfasst, wobei:
- ein oder mehr Schlitze (7) in dem Kühlelement (1) vorgesehen sind, die so angeordnet sind, dass der elektrische Widerstand von Wirbelstromwegen erhöht wird, **dadurch gekennzeichnet, dass** ferner enthalten sind:
- Kühlkanäle (8), die derart in die Schlitze (7) integriert sind, dass eine Vielzahl von parallelen Wegen vorgesehen ist, die so angeordnet sind, dass die Strömungsimpedanz reduziert wird und die innerhalb des Kühlelements ausgebildet sind.

2. Lithographische Projektionsvorrichtung nach Anspruch 1, wobei die Schlitze (7) so angeordnet sind, dass sie im Wesentlichen parallel zueinander verlaufen.

3. Lithographische Projektionsvorrichtung nach einem der vorhergehenden Ansprüche, wobei die Schlitze (7) so angeordnet sind, dass sie im Wesentlichen senkrecht zu der Richtung des induzierten elektrischen Feldes verlaufen.

4. Lithographische Projektionsvorrichtung nach einem der Ansprüche 1-2, wobei die Schlitze (7) so angeordnet sind, dass sie im Wesentlichen parallel oder in einem im Wesentlichen spitzen Winkel zu der Richtung des induzierten elektrischen Feldes verlaufen.

5. Lithographische Projektionsvorrichtung nach einem der vorhergehenden Ansprüche, wobei die Schlitzlängen so begrenzt sind, dass sie nicht über die Gesamtlänge des Kühlelements (1) hinausgehen.

6. Lithographische Projektionsvorrichtung nach einem der vorhergehenden Ansprüche, wobei sich benachbarte Schlitze (7) von gegenüberliegenden Seiten des Kühlelements (1) erstrecken.

7. Lithographische Projektionsvorrichtung nach einem der vorhergehenden Ansprüche, wobei Kühlkanäle (8) in einem im Wesentlichen symmetrischen Netzwerk angeordnet sind, um eine einheitliche Abdeckung des Kühlelements (1) zu schaffen.

8. Lithographische Projektionsvorrichtung nach einem der vorhergehenden Ansprüche, wobei die Schlitze (7) gefüllt sind, um vor Ausgasen aus der Spule (3) zu schützen.

9. Verfahren zur Herstellung eines Bauteils, das folgende Schritte umfasst:
• Bereitstellen eines Substrats (W), das zumindest teilweise von einer Schicht aus strahlungssensitivem Material bedeckt ist;
• Bereitstellen eines Projektionsstrahls aus Strahlung (PB) unter Verwendung eines Strahlungssystems (LA);
• Verwenden von Musteraufbringungseinrichtungen (MA), um dem Projektionsstrahl (PB) in seinem Querschnitt ein Muster aufzuprägen;
• Projizieren des gemusterten Strahls aus Strahlung (PB) auf einen Zielbereich der Schicht aus strahlungssensitivem Material; und
• Betreiben eines Lorentz-Aktuators, der eine Spulenanordnung (3) in Thermokontakt mit wenigstens einem Kühlelement (1) umfasst; wobei:
ein oder mehr Schlitze in dem Kühlelement (1) vorgesehen sind, die so angeordnet sind, dass der elektrische Widerstand von Wirbelstromwegen erhöht wird, **dadurch gekennzeichnet, dass** Kühlkanäle (8) derart in die Schlitze (7) integriert sind, dass eine Vielzahl von parallelen Wegen vorgesehen ist, die so angeordnet sind, dass die Strömungsimpedanz reduziert wird und die innerhalb des Kühlelements ausgebildet sind.

## Revendications

1. Appareil de projection lithographique comprenant :
- un système de rayonnement (LA) pour délivrer un faisceau de projection de rayonnement (PB) ;
- une structure de support (MT) pour supporter des moyens de mise en forme (MA), les moyens de mise en forme (MA) servant à mettre en forme le faisceau de projection (PB) conformément à un motif voulu ;
- une table de substrat (WT) pour maintenir un substrat (W) ;
- un système de projection (PL) pour projeter le faisceau mis en forme (PB) sur une partie cible du substrat (W) ; et
- un actionneur de Lorentz, comprenant un agencement de bobine (3) en contact thermique avec au moins un élément de refroidissement (1), dans lequel :
une ou plusieurs fentes (7) sont fournies dans ledit élément de refroidissement (1), agencées de manière à augmenter la résistance électrique de trajets de courants de Foucault, **caractérisé en ce qu'**il comprend en outre :
- des canaux de refroidissement (8) intégrés dans les fentes (7) de manière à produire une pluralité de trajets parallèles agencés pour réduire l'impédance de flux, et formés à l'intérieur de l'élément de refroidissement.

2. Appareil de projection lithographique selon la revendication 1, dans lequel les fentes (7) sont agencées pour être sensiblement parallèles les unes aux autres.

3. Appareil de projection lithographique selon l'une quelconque des revendications précédentes, dans lequel les fentes (7) sont agencées pour être sensiblement perpendiculaires à la direction du champ électrique induit.

4. Appareil de projection lithographique selon l'une quelconque des revendications 1 et 2, dans lequel les fentes (7) sont agencées pour être sensiblement parallèles, ou à un angle sensiblement oblique, par rapport à la direction du champ électrique induit.

5. Appareil de projection lithographique selon l'une quelconque des revendications précédentes, dans lequel les longueurs de fentes sont limitées de manière à ne pas s'étendre à travers la longueur complète de l'élément de refroidissement (1).

6. Appareil de projection lithographique selon l'une quelconque des revendications précédentes, dans lequel des fentes adjacentes (7) s'étendent à partir de cô tés opposés de l'élément de refroidissement (1).

7. Appareil de projection lithographique selon l'une quelconque des revendications précédentes, dans lequel des canaux de refroidissement (8) sont agencés dans un réseau sensiblement symétrique pour assurer une couverture uniforme de l'élément de refroidissement (1).

8. Appareil de projection lithographique selon l'une quelconque des revendications précédentes, dans lequel les fentes (7) sont remplies pour protéger contre un dégazage à partir de la bobine (3).

9. Procédé de fabrication d'un dispositif comprenant les étapes suivantes :
- fournir un substrat (W) qui est au moins partiellement recouvert d'une couche sensible au rayonnement ;
- délivrer un faisceau de projection de rayonnement (PB) en utilisant un système de rayonnement (LA) ;
- utiliser des moyens de mise en forme (MA) pour doter le faisceau de projection (PB) d'un motif dans sa section transversale ;
- projeter le faisceau de rayonnement (PB) mis en forme sur une partie cible de la couche de matériau sensible au rayonnement ; et
- actionner un actionneur de Lorentz, qui comprend un agencement de bobine (3) en contact thermique avec au moins un élément de refroidissement (1), dans lequel :
- une ou plusieurs fentes sont fournies dans ledit élément de refroidissement (1), agencées de manière à augmenter la résistance électrique de trajets de courants de Foucault, **caractérisé en ce que** des canaux de refroidissement (8) sont intégrés dans les fentes (7) de manière à produire une pluralité de trajets parallèles agencés pour réduire l'impédance de flux, et sont formés à l'intérieur de l'élément de refroidissement.
